# EUROPEAN PATENT APPLICATION

(11) **EP 4 791 179 A1**
(43) Date of publication of application: **12.08.2026**
(21) Application number: 25212651.1
(22) Date of filing: 31.10.2025
(51) Int. Cl.: H10W 70/655, H10W 72/59

(54) **PACKAGE SUBSTRATE WITH A PLATING LAYER AND A SEMICONDUCTOR PACKAGE INCLUDING THE SAME**

(30) Priority: 06.02.2025 KR 20250014870
(71) Applicant: SK hynix Inc., Bubal-eub Icheon-si Gyeonggi-do 17336 (KR)
(72) Inventor: LEE, Ki Yong, Icheon-si, Gyeonggi-do (KR); PARK, Gi Guk, Icheon-si, Gyeonggi-do (KR)
(74) Representative: Isarpatent

(57) **Abstract**

A package substrate includes wirings on a substrate body. Each wiring includes a substrate pad in a boding finger region of the substrate body and a connected trace extending into a chip mounting region of the substrate body. Plating layers are respectively disposed on the substrate pads. Disposed on the substrate body are first and second residual sections of a first plating inlet line respectively connected to first and second traces. An insulating layer covers the first and second traces and residual sections. The insulating layer includes a first opening through which the first and second plating layers are exposed and includes a second opening separating the first residual section from the second residual section. The first trace includes a recessed section on a side facing the second trace, and the second opening is disposed within the recessed section.

## Description

### TECHNICAL FIELD

Embodiments of the present disclosure relate to a package substrate with a plating layer and a semiconductor package including a package substrate.

### BACKGROUND

Packaging technology is a technology that electrically connects the input/output terminals and power terminals of a semiconductor chip with an integrated circuit to an external device, protects the semiconductor chip from external environments such as moisture and dust, and seals the semiconductor chip to withstand mechanical shock.

A wire bonding package is a method of mounting a semiconductor chip on a substrate and connecting the semiconductor chip and the substrate through a bonding wire. The substrate includes a bonding finger to which the bonding wire is connected. The bonding finger is composed of a plating layer containing one or more metals.

The plating layer may be formed by an electroplating method. To form a plating layer by an electroplating method, it is required to form a plating inlet line electrically connected to the bonding finger and apply a plating current to the bonding finger.

### SUMMARY

In accordance with an embodiment of the present disclosure, a package substrate may include: a substrate body; a first wiring disposed on the substrate body, the first wiring including a first substrate pad on a bonding finger region of the substrate body and a first trace connected to the first substrate pad, the first trace extending into a chip mounting region of the substrate body; a second wiring disposed on the substrate body, the second wiring including a second substrate pad on the bonding finger region and a second trace connected to the second substrate pad, the second trace extending into the chip mounting region; a first residual section of a first plating inlet line and a second residual section of the first plating inlet line that are disposed on the substrate body and connected to the first trace and the second trace, respectively; a first plating layer and a second plating layer disposed on the first and second substrate pads, respectively; and an insulating layer that covers the first trace, the second trace, and the first residual section and the second residual section of the first plating inlet line, the insulating layer including a first opening through which the first plating layer and the second plating layer are exposed and including a second opening separating the first residual section of the first plating inlet line from the second residual section of the first plating inlet line, wherein the first trace includes a recessed section on a side facing the second trace, and the second opening is disposed within the recessed section.

In accordance with an embodiment of the present disclosure, a semiconductor package may include a package substrate, a semiconductor chip mounted on the package substrate, and a first connection member and a second connection member connecting the package substrate and the semiconductor chip. In addition, the package substrate may include: a substrate body, wherein the semiconductor chip is mounted in a chip mounting region of the substrate body; a first wiring including a first bonding finger disposed on the substrate body in a bonding finger region of the substrate body, the first bonding finger bonded to the first connection member, the first wiring also including a first trace disposed on the substrate body, the first trace connected to the first bonding finger and extending to the chip mounting region; a second wiring including a second bonding finger disposed on the substrate body in the bonding finger region, the second bonding finger bonded to the second connection member, the second wiring also including a second trace disposed on the substrate body, the second trace connected to the second bonding finger and extending to the chip mounting region; a first residual section of a first plating inlet line and a second residual section of the first plating inlet line disposed on the substrate body, the first and second residual sections connected to the first and second traces, respectively; and an insulating layer covering the first trace, the second trace, and the first and second residual sections of the first plating inlet line, the insulating layer having a first opening through which the first bonding finger and the second bonding finger are exposed and a second opening separating the first residual section of the first plating inlet line from the second residual section of the first plating inlet line, wherein the first trace includes a recessed section on a side facing the second trace, and the second opening is disposed within the recessed section.

### BRIEF DESCRIPTION OF THE DRAWINGS

The present disclosure will be more fully understood from the detailed description and accompanying drawings provided below, which are provided for illustration only and are not intended to limit the present disclosure.
FIGS. 1, 2, and 3 are plan views illustrating a portion of a package substrate according to an embodiment of the present disclosure.
FIG. 4 is a cross-sectional view taken along line A-A' of FIG. 3.
FIG. 5 is a cross-sectional view taken along line B-B' of FIG. 3.
FIG. 6 is a cross-sectional view taken along line C-C' of FIG. 3.
FIG. 7 is a plan view illustrating a preliminary package substrate before a first plating layer to a fifth plating layer of FIG. 3 are formed.
FIG. 8 is a cross-sectional view taken along line D-D' of FIG. 7.
FIG. 9 illustrates a voltage application path in a plating process for forming plating layers according to an embodiment of the present disclosure.
FIG. 10 is a plan view illustrating a portion of a package substrate according to an embodiment of the present disclosure.
FIG. 11 is a cross-sectional view illustrating a portion of a semiconductor package according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," or "under," another element, the elements may directly contact each other, or an intervening element may be disposed between the elements.

Terms such as "vertical," "over," "on," "side," "upper," "front," "row," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

While the detailed embodiments are disclosed in the present application, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope. In the figures, the direction indicated by the arrow and its opposite direction represent the same direction.

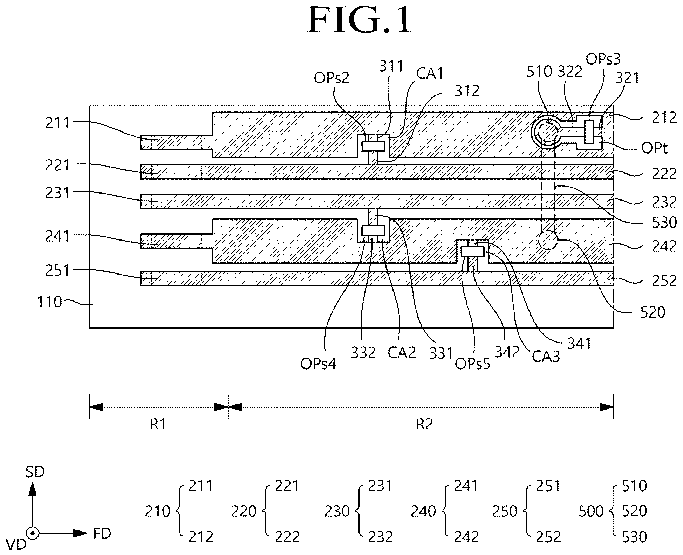

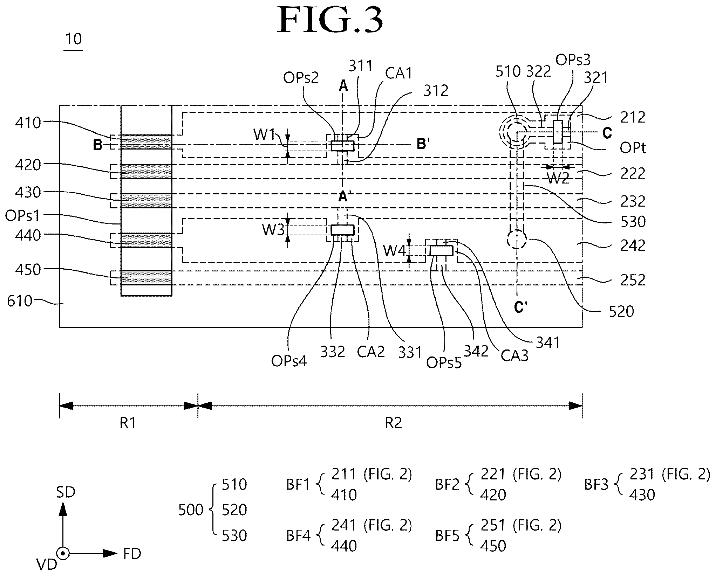

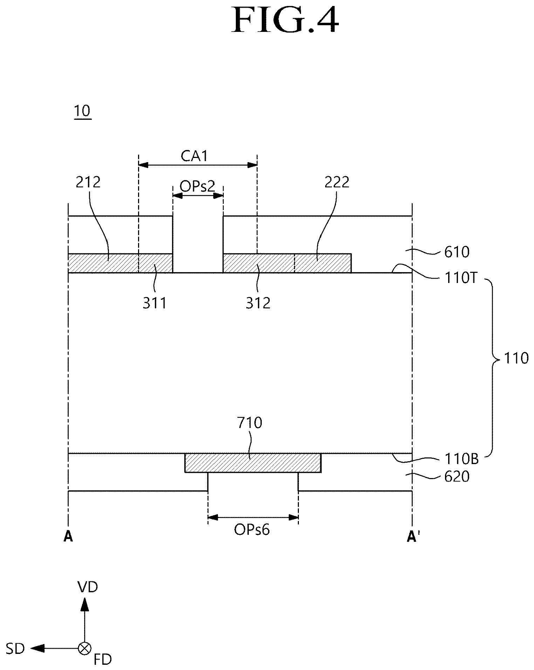

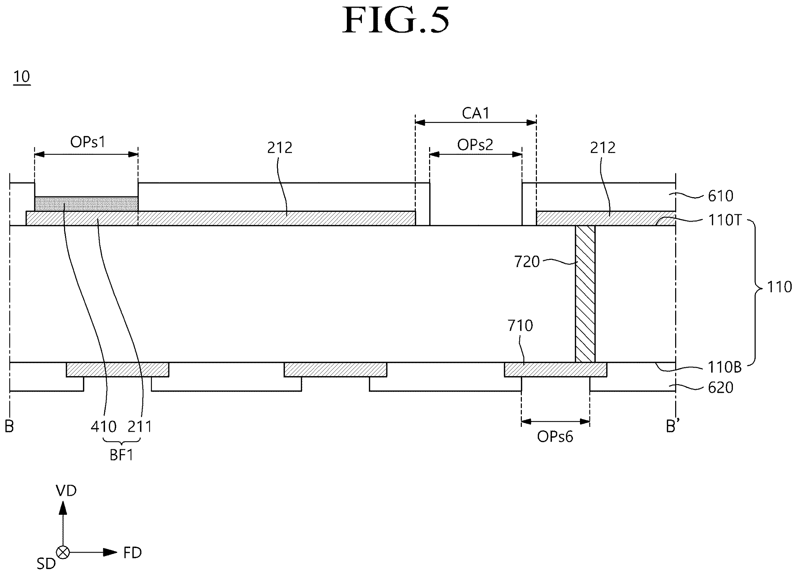

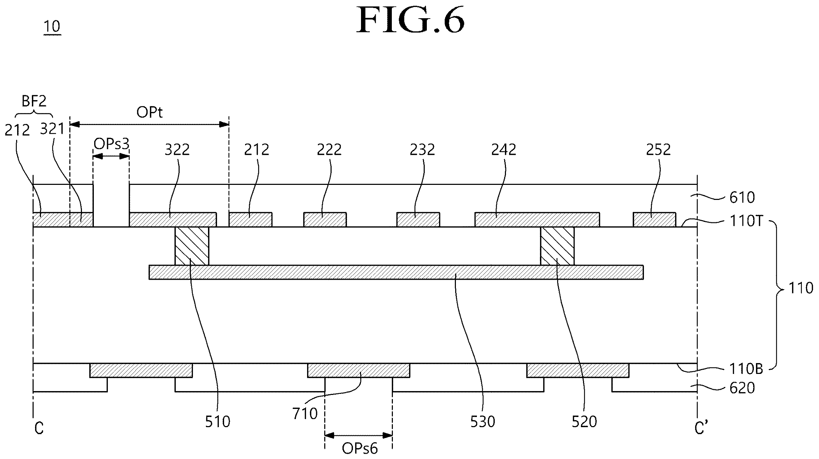

FIG. 1 to FIG. 3 are plan views illustrating a portion of a package substrate according to an embodiment of the present disclosure, FIG. 4 is a cross-sectional view taken along line A-A' of FIG. 3, FIG. 5 is a cross-sectional view taken along line B-B' of FIG. 3, and FIG. 6 is a cross-sectional view taken along line C-C' of FIG. 3.

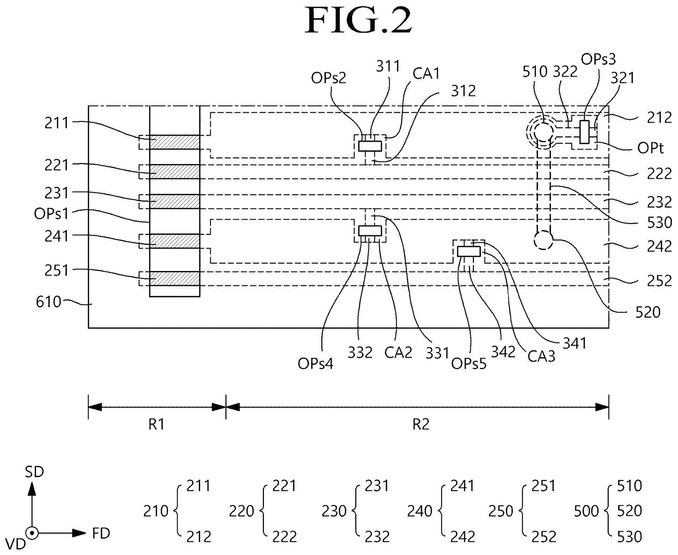

FIG. 1 illustrates components excluding a first plating layer 410, a second plating layer 420, a third plating layer 430, a fourth plating layer 440, a fifth plating layer 450, and a first insulating layer 610 shown in FIG. 3. FIG. 2 illustrates components excluding the first plating layer 410, the second plating layer 420, the third plating layer 430, the fourth plating layer 440, and the fifth plating layer 450 shown in FIG. 3.

Referring to FIG. 1 to FIG. 6, a package substrate 10 includes a substrate body 110.

The substrate body 110 may include a dielectric material. The dielectric material may include an epoxy resin. In an embodiment, the substrate body 110 may have a laminate structure of a plurality of dielectric layers and conductive layers.

The substrate body 110 includes a bonding finger region R1 and a chip mounting region R2. The chip mounting region R2 overlaps with a semiconductor chip mounted on the package substrate 10 in a vertical direction VD. The bonding finger region R1 is arranged on one side of the chip mounting region R2. The bonding finger region R1 is arranged on one side of the chip mounting region R2 in the first direction FD.

The package substrate 10 includes first layer conductive lines arranged on a first surface 110T of the substrate body 110. The first layer conductive lines include a first wiring 210, a second wiring 220, a third wiring 230, a fourth wiring 240, and a fifth wiring 250. The first wiring 210 includes a first substrate pad 211 and a first trace 212, as indicated by the brace in FIGS. 1, 2, and 7. The second wiring 220 includes a second substrate pad 221 and a second trace 222, the third wiring 230 includes a third substrate pad 231 and a third trace 232, the fourth wiring 240 includes a fourth substrate pad 241 and a fourth trace 242, and the fifth wiring 250 includes a fifth substrate pad 251 and a fifth trace 252.

The first substrate pad 211, the second substrate pad 221, the third substrate pad 231, the fourth substrate pad 241, and the fifth substrate pad 251 are disposed in the bonding finger region R1. In one embodiment, the first substrate pad 211, the second substrate pad 221, the third substrate pad 231, the fourth substrate pad 241, and the fifth substrate pad 251 are arranged in a row along a second direction SD to the first direction FD.

The first trace 212, the second trace 222, the third trace 232, the fourth trace 242, and the fifth trace 252 extend from the bonding finger region R1 to the chip mounting region R2. The first trace 212 is connected to the first substrate pad 211 in the bonding finger region R1 and extends from the first substrate pad 211 to the chip mounting region R2. Similar to the first trace 212, the second trace 222, the third trace 232, the fourth trace 242, and the fifth traces 252 are respectively connected to the second substrate pad 221, the third substrate pad 231, the fourth substrate pad 241, and the fifth substrate pad 251 in the bonding finger region R1 and extend from the corresponding substrate pads to the chip mounting region R2.

The second wiring 220, the third wiring 230 and the fifth wiring 250 constitute signal lines. The signal lines may be conductive paths through which data signals or address and command signals are transmitted. The first wiring 210 and the fourth wiring 240 constitute non-signal lines. The non-signal lines include power lines or ground lines. In an embodiment, the first wiring 210 is a ground line, and the fourth wiring 240 is a power line.

The first layer conductive lines include a first residual section 311 and a second residual section 312 of a first plating inlet line, a third residual section 321 and a fourth residual section 322 of a second plating inlet line, a fifth residual section 331 and a sixth residual section 332 of a third plating inlet line, and a seventh residual section 341 and an eighth residual section 342 of a fourth plating inlet line.

The first residual section 311 of the first plating inlet line and the second residual section 312 of the first plating inlet line are disposed between the first trace 212 and the second trace 222 neighboring each other. The first residual section 311 of the first plating inlet line is connected to the first trace 212, and the second residual section 312 of the first plating inlet line is connected to the second trace 222. The first residual section 311 of the first plating inlet line and the second residual section 312 of the first plating inlet line are separated from each other by a second opening OPs2.

The first residual section 311 of the first plating inlet line and the second residual section 312 of the first plating inlet line may be arranged in a line along a direction intersecting the direction in which the first trace 212 and the second trace 222 extend. Intersecting directions, for example, may be perpendicular directions or directions that are not parallel or antiparallel to each other. The first trace 212 and the second trace 222 extend in the first direction FD, and the first residual section 311 of the first plating inlet line and the second residual section 312 of the first plating inlet line may be arranged in a line along a second direction SD perpendicular to the first direction FD. The first trace 212 has a first recessed section CA1 on a side facing the second trace 222. In a planar view, the first residual section 311 of the first plating inlet line and the second opening Ops2 are disposed within the first recessed section CA1.

The first recessed section CA1 is arranged in the chip mounting region R2. The first residual section 311 and the second residual section 312 of the first plating inlet line are also arranged in the chip mounting region R2.

The first trace 212 has a trace opening OPt through which the first surface 110T of the substrate body 110 is partially exposed. The third residual section 321 and the fourth residual section 322 of the second plating inlet line are disposed on the first surface 110T of the substrate body 110 exposed by the trace opening OPt. One end of the third residual section 321 of the second plating inlet line is connected to the first trace 212, and one end of the fourth residual section 322 of the second plating inlet line is connected to a connection circuit 500. The third residual section 321 of the second plating inlet line and the fourth residual section 322 of the second plating inlet line are separated from each other by a third opening OPs3.

The third residual section 321 of the second plating inlet line and the fourth residual section 322 of the second plating inlet line may be arranged in a line along the direction in which the first trace 212 extends. The first trace 212 extends in the first direction FD, and the third residual section 321 of the second plating inlet line and the fourth residual section 322 of the second plating inlet line may be arranged in a line along the first direction FD.

The trace opening OPt is disposed in the chip mounting region R2. The third residual section 321 and the fourth residual section 322 of the second plating inlet line are also disposed in the chip mounting region R2.

The connection circuit 500 includes a first via 510, a second via 520, and a connection wiring 530. This is indicated in FIGS. 1, 2, 3, 7, and 9 by a brace.

The first via 510 penetrates the first surface 110T of the substrate body 110 under the fourth residual section 322 of the second plating inlet line. The fourth residual section 322 of the second plating inlet line is in contact with an upper surface of the first via 510 and is electrically connected to the first via 510.

The second via 520 penetrates the first surface 110T of the substrate body 110 under the fourth trace 242. The fourth trace 242 contacts an upper surface of the second via 520 and is electrically connected to the second via 520.

The connection wiring 530 electrically connects the first via 510 and the second via 520, as shown in FIG. 6. The package substrate 10 includes an internal wiring layer disposed between the first surface 110T and a second surface 110B of the substrate body 110. The connection wiring 530 is disposed in the internal wiring layer.

The fourth trace 242 is connected to the fourth residual section 322 of the second plating inlet line through the second via 520, the connection wiring 530, and the first via 510. The fourth trace 242 is electrically separated from the third residual section 321 of the second plating inlet line and the first wiring 210 by the third opening OPs3.

The fifth residual section 331 and the sixth residual section 332 of a third plating inlet line are disposed between the third trace 232 and the fourth trace 242 neighboring each other. The fifth residual section 331 of the third plating inlet line is connected to the third trace 232, and the sixth residual section 332 of the third plating inlet line is connected to the fourth trace 242. The fifth residual section 331 of the third plating inlet line and the sixth residual section 332 of the third plating inlet line are separated from each other by a fourth opening OPs4.

The fifth residual section 331 of the third plating inlet line and the sixth residual section 332 of the third plating inlet line may be arranged in a line along a direction intersecting the direction in which the third trace 232 and the fourth trace 242 extend. The third trace 232 and the fourth trace 242 extend in the first direction FD, and the fifth residual section 331 and the sixth residual section 332 of the third plating inlet line may be arranged in a line along the second direction SD.

The fourth trace 242 has a second recessed section CA2 on a side facing the third trace 232. In a planar view, the sixth residual section 332 of the third plating inlet line and the fourth opening OPs4 are arranged within the second recessed section CA2.

The second recessed section CA2 is disposed in the chip mounting region R2. The fifth residual section 331 and the sixth residual section 332 of the third plating inlet line are also disposed in the chip mounting region R2.

The seventh residual section 341 and the eighth residual section 342 of a fourth plating inlet line are arranged between the fourth trace 242 and the fifth trace 252 that are neighboring each other. The seventh residual section 341 of the fourth plating inlet line is connected to the fourth trace 242, and the eighth residual section 342 of the fourth plating inlet line is connected to the fifth trace 252. The seventh residual section 341 of the fourth plating inlet line and the eighth residual section 342 of the fourth plating inlet line are separated from each other by a fifth opening OPs5.

The seventh residual section 341 of the fourth plating inlet line and the eighth residual section 342 of the fourth plating inlet line may be arranged in a line along a direction intersecting the direction in which the fourth trace 242 and the fifth trace 252 extend. The fourth trace 242 and the fifth trace 252 extend in the first direction FD, and the seventh residual section 341 and the eighth residual section 342 of the fourth plating inlet line may be arranged in a row along the second direction SD.

The fourth trace 242 has a third recessed section CA3 on a side facing the fifth trace 252. In a planar view, the seventh residual section 341 and the fifth opening OPs5 of the third plating inlet line are arranged within the third recessed section CA3.

The third recessed section CA3 is arranged in the chip mounting region R2. The seventh residual section 341 and the eighth residual section 342 of the fourth plating inlet line are also arranged in the chip mounting region R2.

A first insulating layer 610 is disposed on a first surface 110T of a substrate body 110, as shown in FIGS. 4-6, and a second insulating layer 620 is disposed on a second surface 110B of the substrate body 110. The first insulating layer 610 and the second insulating layer 620 may include a solder resist.

The first insulating layer 610 covers the first trace 212, the second trace 222, the third trace 232, the fourth trace 242 and the fifth trace 252, the first residual section 311 and the second residual section 312 of the first plating inlet line, the third residual section 321 and the fourth residual section 322 of the second plating inlet line, the fifth residual section 331 and the sixth residual section 332 of the third plating inlet line, and the seventh residual section 341 and the eighth residual section 342 of the fourth plating inlet line.

The space between the first trace 212 and the first residual section 311 and the second residual section 312 of the first plating inlet line in the first recessed section CA1 may be filled with the first insulating layer 610.

The space between the first trace 212 and the third residual section 321 and the fourth residual section 322 of the second plating inlet line in the trace opening OPt may be filled with the first insulating layer 610. The space between the fourth trace 242 and the fifth residual section 331 and the sixth residual section 332 of the third plating inlet line in the second recessed section CA2 may be filled with the first insulating layer 610. The space between the fourth trace 242 and the seventh residual section 341 and the eighth residual section 342 of the fourth plating inlet line in the third recessed section CA3 may be filled with the first insulating layer 610.

The first insulating layer 610 has a first opening OPs1 through which the first substrate pad 211, the second substrate pad 221, the third substrate pad 231, the fourth substrate pad 241, and the fifth substrate pad 251 are exposed. The first opening OPs1 penetrates the first insulating layer 610 in the vertical direction VD. The first opening OPs1 may be configured in a line shape extending in the second direction SD to simultaneously expose the first substrate pad 211, the second substrate pad 221, the third substrate pad 231, the fourth substrate pad 241, and the fifth substrate pad 251 arranged in a row along the second direction SD. In response to the arrangement structure of the first substrate pad 211, the second substrate pad 221, the third substrate pad 231, the fourth substrate pad 241, and the fifth substrate pad 251 arranged in a single row along the second direction SD, the first opening OPs1 having a line shape extending in the second direction SD may be formed in the first insulating layer 610. The first surface 110T of the substrate body 110 is exposed by the first opening OPs1.

The second opening OPs2 penetrates the first insulating layer 610 in the vertical direction VD. The second opening OPs2 separates the first residual section 311 of the first plating inlet line and the second residual section 312 of the first plating inlet line. The first residual section 311 of the first plating inlet line and the second residual section 312 of the first plating inlet line are electrically separated by the second opening OPs2. Thus, one side of the first residual section 311 of the first plating inlet line and one side of the second residual section 312 of the first plating inlet line may be exposed by the second opening OPs2. Likewise, one side of the first residual section 311 of the first plating inlet line and one side of the second residual section 312 of the first plating inlet line may face each other in the second direction SD. The dimension of the second opening OPs2 in the second direction SD has a distance of W1. Thus, one side of the first residual section 311 of the first plating inlet line and one side of the second residual section 312 of the first plating inlet line may be spaced apart from each other by the distance of W1 in the second direction SD. The first surface 110T of the substrate body 110 is exposed by the second opening OPs2.

The third opening OPs3 penetrates the first insulating layer 610 in the vertical direction VD. The third opening OPs3 separates the third residual section 321 of the second plating inlet line and the fourth residual section 322 of the first plating inlet line. The third residual section 321 of the second plating inlet line and the fourth residual section 322 of the second plating inlet line are electrically separated by the third opening OPs3. Thus, one side of the third residual section 321 of the second plating inlet line and one side of the fourth residual section 322 of the second plating inlet line may be exposed by the third opening OPs3. Likewise, one side of the third residual section 321 of the second plating inlet line and one side of the fourth residual section 322 of the second plating inlet line may face each other in the first direction FD. The dimension of the third opening OPs3 in the first direction FD has a distance of W2, and one side of the third residual section 321 of the second plating inlet line and one side of the fourth residual section 322 of the second plating inlet line may be spaced apart from each other by the distance of W2 in the first direction FD. The first surface 110T of the substrate body 110 is exposed by the third opening OPs3.

The fourth opening OPs4 penetrates the first insulating layer 610 in the vertical direction VD. The fourth opening OPs4 separates the fifth residual section 331 of the third plating inlet line and the sixth residual section 332 of the third plating inlet line. The fifth residual section 331 of the third plating inlet line and the sixth residual section 332 of the third plating inlet line are electrically separated by the fourth opening OPs4. Thus, one side of the fifth residual section 331 of the third plating inlet line and one side of the sixth residual section 332 of the third plating inlet line may be exposed by the fourth opening OPs4. Likewise, one side of the fifth residual section 331 of the third plating inlet line and one side of the sixth residual section 332 of the third plating inlet line may face each other in the second direction SD. The dimension of the fourth opening OPs4 in the second direction SD has a distance of W3, and one side of the fifth residual section 331 of the third plating inlet line and one side of the sixth residual section 332 of the third plating inlet line may be spaced apart from each other by the distance of W3 in the second direction SD. The first surface of the substrate body 110 is exposed by the fourth opening OPs4.

The fifth opening OPs5 penetrates the first insulating layer 610 in the vertical direction VD. The fifth opening OPs5 separates the seventh residual section 341 of the fourth plating inlet line and the eighth residual section 342 of the fourth plating inlet line. The seventh residual section 341 of the fourth plating inlet line and the eighth residual section 342 of the fourth plating inlet line are electrically separated by the fifth opening OPs5. Thus, one side of the seventh residual section 341 of the fourth plating inlet line and one side of the eighth residual section 342 of the fourth plating inlet line may be exposed by the fifth opening OPs5. Likewise, one side of the seventh residual section 341 of the fourth plating inlet line and one side of the eighth residual section 342 of the fourth plating inlet line may face each other in the second direction SD. The dimension of the fifth opening OPs5 in the second direction SD has a distance of W4, and one side of the seventh residual section 341 of the fourth plating inlet line and one side of the eighth residual section 342 of the fourth plating inlet line may be spaced apart from each other by the distance of W4 in the second direction SD. The first surface 110T of the substrate body 110 is exposed by the fifth opening OPs5.

The package substrate 10 includes second layer conductive lines on a second surface 110B of the substrate body 110. The second layer conductive lines include ball lands 710. The second layer conductive lines are electrically connected to the first layer conductive lines by through vias 720 that penetrate the substrate body 110 in a vertical direction VD, as illustrated in FIG. 5.

A second insulating layer 620 covers the second surface 110B of the substrate body 110. The second insulating layer 620 has a sixth opening Ops6 through which the ball lands 710 are exposed.

The first plating layer 410, the second plating layer 420, the third plating layer 430, the fourth plating layer 440, and the fifth plating layer 450 are respectively arranged on the first substrate pad 211, the second substrate pad 221, the third substrate pad 231, the fourth substrate pad 241, and the fifth substrate pad 251 (see, e.g., FIGS. 3 and 5). A first bonding finger BF1 includes the first substrate pad 211 and the first plating layer 410. A second bonding finger BF2 includes the second substrate pad 221 and the second plating layer 420. A third bonding finger BF3 includes the third substrate pad 231 and the third plating layer 430. A fourth bonding finger BF4 includes the fourth substrate pad 241 and the fourth plating layer 440.

The first plating layer 410, the second plating layer 420, the third plating layer 430, the fourth plating layer 440, and the fifth plating layer 450 may be formed of a different conductive material from the conductive material forming the first wiring 210, the second wiring 220, the third wiring 230, the fourth wiring 240, and the fifth wiring 250. For example, the first wiring 210, the second wiring 220, the third wiring 230, the fourth wiring 240, and the fifth wiring 250 may include a copper (Cu) layer, and the first plating layer 410, the second plating layer 420, the third plating layer 430, the fourth plating layer 440, and the fifth plating layer 450 may include at least one of a nickel (Ni) layer and a gold (Au) layer.

In manufacturing a package, connection members may be bonded on the first plating layer 410, the second plating layer 420, the third plating layer 430, the fourth plating layer 440, and the fifth plating layer 450, respectively. The connection members may include bonding wires. The first plating layer 410, the second plating layer 420, the third plating layer 430, the fourth plating layer 440, and the fifth plating layer 450 may be formed as layers that increase adhesive strength between the first substrate pad 211, the second substrate pad 221, the third substrate pad 231, the fourth substrate pad 241, and the fifth substrate pad 251 and the bonding wires, or that improve electrical conductivity between the first substrate pad 211, the second substrate pad 221, the third substrate pad 231, the fourth substrate pad 241, and the fifth substrate pad 251 and the bonding wires. The first plating layer 410, the second plating layer 420, the third plating layer 430, the fourth plating layer 440, and the fifth plating layer 450 may be formed as layers that prevent, reduce, or mitigate corrosion and contamination of the first substrate pad 211, the second substrate pad 221, the third substrate pad 231, the fourth substrate pad 241, and the fifth substrate pad 251.

The first plating layer 410, the second plating layer 420, the third plating layer 430, the fourth plating layer 440, and the fifth plating layer 450 may be formed by an electrolytic plating process. The electrolytic plating process includes applying a plating current to the first substrate pad 211, the second substrate pad 221, the third substrate pad 231, the fourth substrate pad 241, and the fifth substrate pad 251.

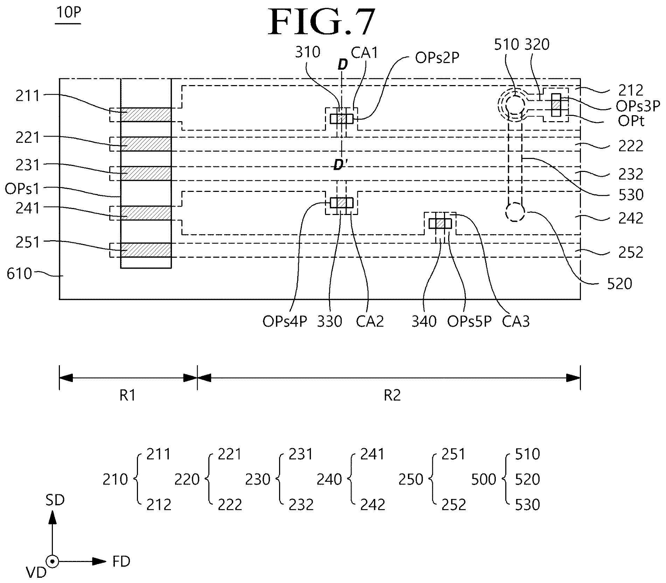

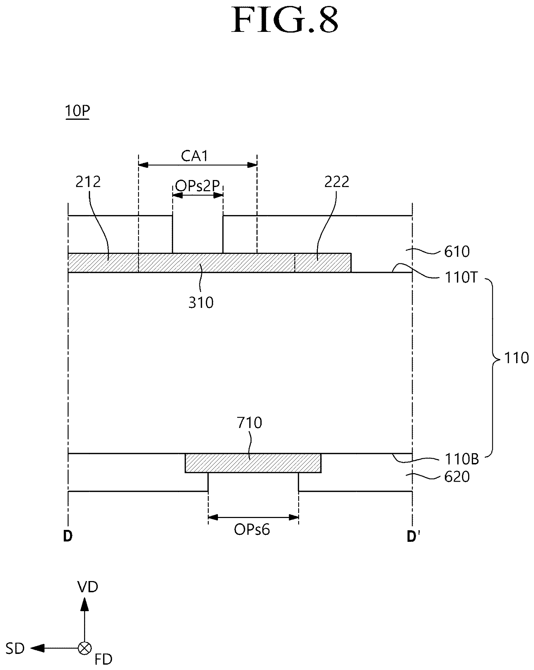

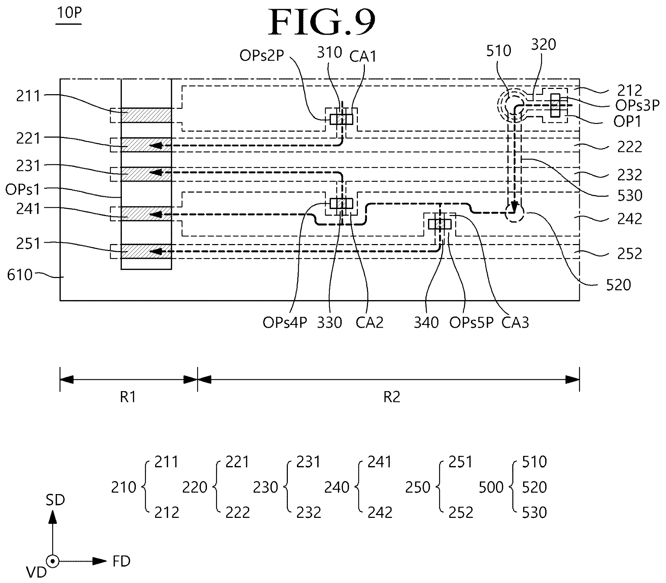

FIG. 7 is a plan view illustrating a preliminary package substrate before the first plating layer 410, the second plating layer 420, the third plating layer 430, the fourth plating layer 440, and the fifth plating layer 450 of FIG. 3 are formed. FIG. 8 is a cross-sectional view taken along line D-D' of FIG. 7, and FIG. 9 illustrates a voltage application path in a plating process for forming plating layers according to an embodiment of the present disclosure.

Referring to FIG. 7 and FIG. 8, a preliminary package substrate 10P includes a plating application structure. The plating application structure includes the first wiring 210, the second wiring 220, the third wiring 230, the fourth wiring 240, and the fifth wiring 250; the first plating inlet line 310, the second plating inlet line 320, the third plating inlet line 330, and the fourth plating inlet line 340; and a connection circuit 500. The plating current can be applied to the first substrate pad 211, the second substrate pad 221, the third substrate pad 231, the fourth substrate pad 241, and the fifth substrate pad 251 through the plating application structure.

The first insulating layer 610 of the preliminary package substrate 10P has a first opening OPs1 and a second preliminary opening OPs2P, a third preliminary opening Ops3P, a fourth preliminary opening Ops4P, and a fifth preliminary opening OPs5P. The first substrate pad 211, the second substrate pad 221, the third substrate pad 231, the fourth substrate pad 241, and the fifth substrate pad 251 are exposed by the first opening OPs1. The second preliminary opening OPs2P is a pre-structure for forming the second opening OPs2 of FIG. 3, and the middle section of the first plating inlet line 310 is exposed by the second preliminary opening OPs2P. The third preliminary opening OPs3P is a pre-structure for forming the third opening OPs3 of FIG. 3, and the middle section of the second plating inlet line 320 is exposed by the third preliminary opening OPs3P. The fourth preliminary opening OPs4P is a pre-structure for forming the fourth opening OPs4 of FIG. 3, and the middle section of the third plating inlet line 330 is exposed by the fourth preliminary opening OPs4P. The fifth preliminary opening OPs5P is a pre-structure for forming the fifth opening OPs5 of FIG. 3, and the middle section of the fourth plating inlet line 340 is exposed by the fifth preliminary opening OPs5P.

The first plating inlet line 310 connects the first trace 212 and the second trace 222 that are neighboring each other. The first plating inlet line 310 provides a passage through which a plating current applied to the first wiring 210 during an electroplating process can flow to the second wiring 220. The first plating inlet line 310 is a temporary conductive line that is electrically disconnected after the electroplating process.

The first plating inlet line 310 is arranged in the chip mounting region R2 of the substrate body 110. A part of the first plating inlet line 310 is arranged within the first recessed section CA1 of the first wiring 210.

The second substrate pad 221 is electrically connected to the first wiring 210 through the second trace 222 and the first plating inlet line 310. As shown in FIG. 9, the plating current applied to the first wiring 210 is transferred to the second substrate pad 221 through the first plating inlet line 310 and the second trace 222. Because the plating current is applied to the second substrate pad 221, the second plating layer 420 of FIG. 3 may be formed on the second substrate pad 221 through an electrolytic plating process.

The second plating inlet line 320 connects the first trace 212 and the connection circuit 500. The second plating inlet line 320 is arranged within the trace opening OPt. The trace opening OPt is arranged in the chip mounting region R2, and the second plating inlet line 320 is also arranged in the chip mounting region R2.

The fourth wiring 240 is connected to the first wiring 210 through the connection circuit 500 and the second plating inlet line 320. The second plating inlet line 320 provides a path through which the plating current applied to the first wiring 210 during the electroplating process can flow to the fourth wiring 240. The second plating inlet line 320 is a temporary conductive line that is electrically disconnected after the electroplating process.

The fourth substrate pad 241 is electrically connected to the first wiring 210 through the fourth trace 242, the connection circuit 500, and the second plating inlet line 320. As shown in FIG. 9, the plating current applied to the first wiring 210 is transmitted to the fourth substrate pad 241 through the second plating inlet line 320, the connection circuit 500, and the fourth trace 242. Because the plating current is applied to the fourth substrate pad 241, the fourth plating layer 440 of FIG. 3 can be formed on the fourth substrate pad 241 through an electrolytic plating process.

The third plating inlet line 330 connects the neighboring third trace 232 and the fourth trace 242. The third plating inlet line 330 provides a path through which the plating current applied to the fourth wiring 240 can flow to the third wiring 230 during the electrolytic plating process. The third plating inlet line 330 is a temporary conductive line that is electrically disconnected after the electrolytic plating process.

The third plating inlet line 330 is arranged in the chip mounting region R2 of the substrate body 110. A part of the third plating inlet line 330 is arranged within the second recessed section CA2 of the fourth wiring 240.

The third substrate pad 231 is connected to the fourth wiring 240 through the third trace 232 and the third plating inlet line 330. As shown in FIG. 9, the plating current applied from the first wiring 210 to the fourth wiring 240 through the second plating inlet line 320 and the connection circuit 500 is transferred to the third substrate pad 231 through the third plating inlet line 330 and the third trace 232. Because the plating current is applied to the third substrate pad 231, the third plating layer 430 of FIG. 3 can be formed on the third substrate pad 231 through the electrolytic plating process.

The fourth plating inlet line 340 connects the fourth trace 242 and the fifth trace 252 that are neighboring each other. The fourth plating inlet line 340 provides a passage for the plating current applied to the fourth wiring 240 to flow to the fifth wiring 250 during the electroplating process. The fourth plating inlet line 340 is a temporary conductive line that is electrically disconnected after the electroplating process.

The fourth plating inlet line 340 is arranged in the chip mounting region R2 of the substrate body 110. A part of the fourth plating inlet line 340 is arranged within the third recessed section CA3 of the fourth wiring 240.

The fifth substrate pad 251 is connected to the fourth wiring 240 through the fifth trace 252 and the fourth plating inlet line 340. As shown in FIG. 9, the plating current applied from the first wiring 210 to the fourth wiring 240 through the second plating inlet line 320 and the connection circuit 500 is transferred to the fifth substrate pad 251 through the fourth plating inlet line 340 and the fifth trace 252. Because the plating current is applied to the fifth substrate pad 251, the fifth plating layer 450 of FIG. 3 can be formed on the fifth substrate pad 251 through an electrolytic plating process.

Although not shown, plating layers are formed on the middle section of the first plating inlet line 310 exposed through the second preliminary opening OPs2P in the electroplating process, the middle section of the second plating inlet line 320 exposed through the third preliminary opening OPs3P, the middle section of the third plating inlet line 330 exposed through the fourth preliminary opening OPs4P, and the middle section of the fourth plating inlet line 340 exposed through the fifth preliminary opening OPs5P.

After the electroplating process is completed, the plating layers exposed through the second preliminary opening OPs2P, the third preliminary opening Ops3P, the fourth preliminary opening Ops4P and the middle section of the first plating inlet line 310, the second plating inlet line 320, the third plating inlet line 330, and the fourth plating inlet line 340 under the plating layers are removed. The plating layer exposed by the second preliminary opening OPs2P and the middle section of the first plating inlet line 310 under the plating layer are removed, thereby forming the second opening OPs2 of FIG. 3. The plating layer exposed by the third preliminary opening Ops3P and the middle section of the second plating inlet line 320 under the plating layer are removed, thereby forming the third opening Ops3 of FIG. 3. The plating layer exposed by the fourth preliminary opening Ops4P and the middle section of the third plating inlet line 330 under the plating layer are removed, thereby forming the fourth opening Ops4 of FIG. 3. The plating layer exposed by the fifth preliminary opening Ops5P and the middle section of the fourth plating inlet line 340 under the plating layer are removed, thereby forming the fifth opening Ops5 of FIG. 3.

Referring to FIG. 3 again, the second opening OPs2 is formed to cut off the middle section of the first plating inlet line (310 of FIG. 6). The second opening OPs2 separates the first plating inlet line (310 of FIG. 7) into the first residual section 311 and the second residual section 312. The first residual section 311 and the second residual section 312 are separated by the second opening OPs2 into an open state, and the first wiring 210 and the second wiring 220 are electrically separated from each other.

The third opening OPs3 is formed to cut off the middle section of the second plating inlet line (320 of FIG. 6). The third opening OPs3 separates the second plating inlet line (320 of FIG. 7) into the third residual section 321 and the fourth residual section 322. The third residual section 321 and the fourth residual section 322 are separated by the third opening OPs3 into an open state, and the first wiring 210 and the fourth wiring 240 are electrically separated from each other.

The fourth opening OPs4 is formed to cut off the middle section of the third plating inlet line (330 of FIG. 7). The fourth opening OPs4 separates the third plating inlet line (330 of FIG. 7) into the fifth residual section 331 and the sixth residual section 332. The fifth residual section 331 and the sixth residual section 332 are separated by the fourth opening OPs4 to be an open or disconnected state, and the third wiring 230 and the fourth wiring 240 are electrically separated from each other.

The fifth opening OPs5 is formed to cut off the middle section of the fourth plating inlet line (340 in FIG. 7). The fifth opening OPs5 separates the fourth plating inlet line (340 in FIG. 7) into a seventh residual section 341 and an eighth residual section 342. The seventh residual section 341 and the eighth residual section 342 are separated by the fifth opening OPs5 into an open state, and the fourth wiring 240 and the fifth wiring 250 are electrically separated from each other.

The process of forming the second opening Ops2, the third opening Ops3, the fourth opening Ops4, and the fifth opening Ops5 includes covering the first plating layer 410, the second plating layer 420, the third plating layer 430, the fourth plating layer 440, and the fifth plating layer 450 on the first insulating layer 610; forming a mask pattern having openings exposing the second preliminary opening OPs2P, the third preliminary opening Ops3P, the fourth preliminary opening Ops4P, and the fifth preliminary opening OPs5P; and removing the plating layers and the middle sections of the first plating inlet line 310, the second plating inlet line 320, the third plating inlet line 330, and the fourth plating inlet line 340 under the plating layers exposed through the mask pattern and the second preliminary opening OPs2P, the third preliminary opening Ops3P, the fourth preliminary opening Ops4P, and the fifth preliminary opening OPs5P by an etching process.

The mask pattern may include a photoresist. The mask pattern may be formed by forming a photoresist on the substrate body 110 and forming openings that expose the second preliminary opening OPs2P, the third preliminary opening Ops3P, the fourth preliminary opening Ops4P, and the fifth preliminary opening OPs5P in the photoresist through exposure and development processes. The photoresist may be formed by laminating a photoresist film processed in the form of a dry film on the substrate body 110.

In the etching process, an alkaline solution capable of melting the plating layers and the first plating inlet line 310, the second plating inlet line 320, the third plating inlet line 330, and the fourth plating inlet line 340 may be used as an etchant. The mask pattern remaining after the etching process may be removed by a strip process.

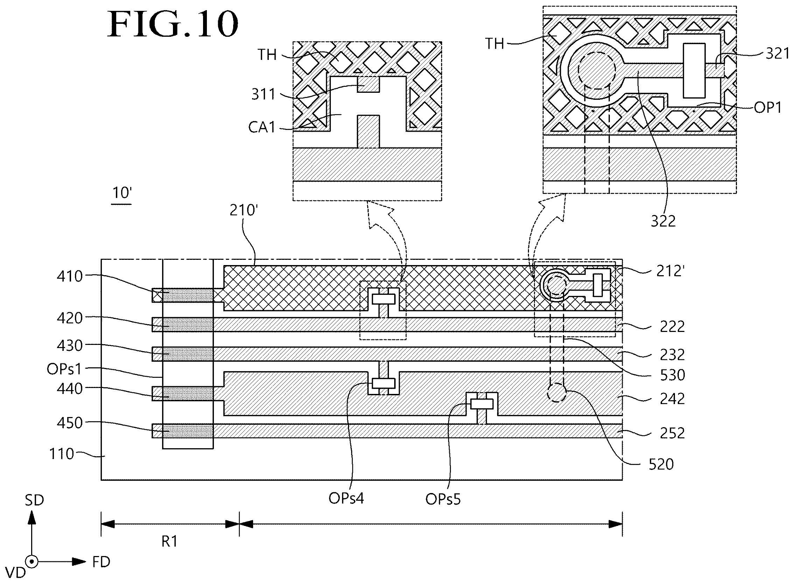

FIG. 10 is a plan view illustrating a portion of a package substrate according to an embodiment of the present disclosure.

Referring to FIG. 10, a first wiring 210' may have a mesh structure. That is, the first wiring 210' may include a plurality of through holes TH.

As shown in FIG. 10, the through holes TH may have a rhombus shape. As another example, the through holes TH may have a polygonal shape, such as a triangle, rectangle, square, or pentagon, or may have a circular or oval shape. FIG. 10 shows a case where the through holes TH are arranged regularly, but as another example, the through holes TH may be arranged irregularly.

The first wiring 210' may be configured so that the through holes TH are not exposed on the side that contacts the first residual section 311 of the first plating inlet line. The first wiring 210' may be configured so that the through holes TH are not exposed on the side that contacts the third residual section 321 of the second plating inlet line.

Because the through holes TH are not exposed to the side of the first wiring 210' that is in contact with the first residual section 311 of the first plating inlet line and the side of the first wiring 210' that is in contact with the third residual section 321 of the second plating inlet line, it is possible to prevent, mitigate, or reduce the contact area between the first wiring 210' and the first residual section 311 of the first plating inlet line and the contact area between the first wiring 210' and the third residual section 321 of the second plating inlet line from being reduced due to the through holes TH, and to prevent, mitigate, or reduce the contact resistance between the first wiring 210' and the first residual section 311 of the first plating inlet line and the contact resistance between the first wiring 210' and the third residual section 321 of the second plating inlet line from being increased due to the through holes TH.

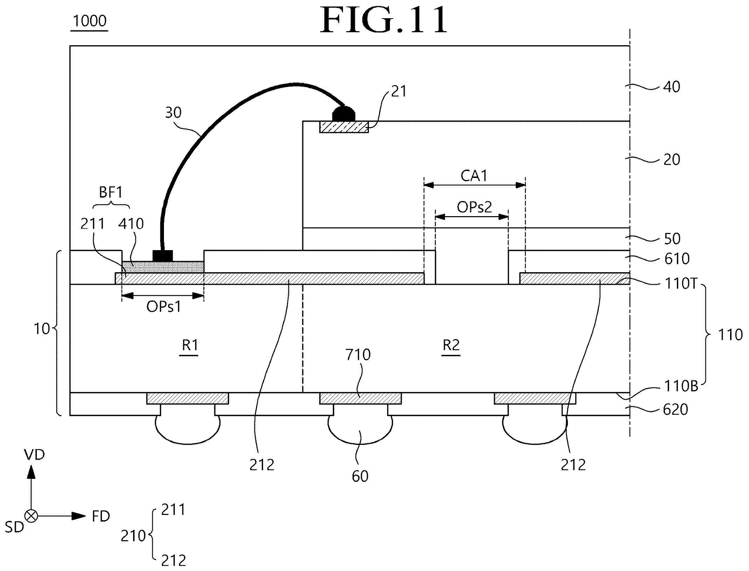

FIG. 11 is a cross-sectional view illustrating a portion of a semiconductor package according to an embodiment of the present disclosure.

Referring to FIG. 11, a semiconductor package 1000 includes a package substrate 10, a semiconductor chip 20, a connection member 30, and a mold layer 40.

The package substrate 10 may be the package substrate described above with reference to FIGS. 1 to 6. As another example, the package substrate 10 may be the package substrate described above with reference to FIG. 10. Because the package substrate 10 has been described above, a duplicate description is omitted here.

The semiconductor chip 20 is mounted on the package substrate 10. FIG. 11 includes one semiconductor chip but is not limited thereto. The number of semiconductor chips may be two or more. For a plurality of semiconductor chips, two or more of the semiconductor chips may be stacked on the chip mounting region R2.

The semiconductor chip 20 may include, but is not limited to, nonvolatile memory, such as NAND, NOR, PRAM (Phase-Change Random-Access Memory) and MRAM (MagnetoResistive Random-Access Memory), volatile memory such as DRAM (Dynamic Random-Access Memory) and SRAM (Static Random-Access Memory), and a processor, such as a logic circuit.

The semiconductor chip 20 has a front surface on which a chip pad 21 is located and a back surface opposite to the front surface. An adhesive member 50 is arranged on the back surface of the semiconductor chip 20. The adhesive member 50 attaches the back surface of the semiconductor chip 20 to the first insulating layer 610 of the package substrate 10. A second opening OPs2 in the first insulating layer 610 of the package substrate 10 is filled with the adhesive member 50. The third opening Ops3, the fourth opening Ops4, and the fifth opening OPs5 of FIG. 3 may also be filled with the adhesive member 50.

The connection member 30 connects the chip pad 21 of the semiconductor chip 20 and the first plating layer 410 of the package substrate 10. One end of the connection member 30 is bonded to the chip pad 21 of the semiconductor chip 20, and the other end of the connection member 30 is bonded to the first plating layer 410 of the package substrate 10. The connection member 30 includes a bonding wire.

In FIG. 11, only the first wiring 210, the first plating layer 410 on the first substrate pad 211 of the first wiring 210, and one connection member 30 connecting the first plating layer 410 and the semiconductor chip 20 are shown, but as described above with reference to FIGS. 1 to 6, the package substrate 10 may include a plurality of wirings, a plurality of plating layers, and the semiconductor package 1000 may include a plurality of connection members connecting the plurality of plating layers and the semiconductor chip.

The mold layer 40 is formed on the package substrate 10 to cover the semiconductor chip 20 and the connection member 30. The mold layer 40 includes an insulating layer. The insulating layer may include an epoxy molding compound (EMC). The epoxy molding compound may include a resin and a filler.

An external connection terminal 60 is connected to a ball land 710 of the package substrate 10. The external connection terminal 60 may include a solder ball.

Hereinafter, some potential effects according to the present disclosure are described.

In an electrolytic plating process for forming a plating layer on a substrate pad, a plating inlet line used for applying a plating current to the substrate pad may be connected to the end of the substrate pad. In this case, because a separate additional area is used outside the chip mounting region and the bonding finger region for arranging the plating inlet line, the area of the chip mounting region is reduced by the size of the additional area, and the size of the semiconductor chip mounted in the chip mounting region and the capacity of the semiconductor chip may be reduced.

According to some embodiments of the present disclosure, because the plating inlet line is connected to a trace rather than a substrate pad, a separate additional area does not need to be formed outside the chip mounting region and the bonding finger region for arranging the plating inlet line. Therefore, the plating inlet line can be arranged without reducing the area of the chip mounting region. In addition, because a recessed section is formed on the side of the trace and the plating inlet line is disposed within the recessed section, the plating inlet line may be disposed without increasing the layout area of the package substrate.

Those skilled in the art will understand that various modifications, additions, and/or substitutions can be made to the detailed embodiments presented herein without departing from the scope and technical concepts of the present disclosure. Therefore, the scope of the present disclosure should not be limited to the presented embodiments. All changes within the meaning and range of equivalency of the claims are included within their scope.

## Claims

1. A package substrate comprising:
a substrate body;
a first wiring disposed on the substrate body, the first wiring including a first substrate pad on a bonding finger region of the substrate body and a first trace connected to the first substrate pad, the first trace extending into a chip mounting region of the substrate body;
a second wiring disposed on the substrate body, the second wiring including a second substrate pad on the bonding finger region and a second trace connected to the second substrate pad, the second trace extending into the chip mounting region;
a first residual section of a first plating inlet line and a second residual section of the first
plating inlet line, the first residual section and the second residual section are disposed on the substrate body and are connected to the first trace and the second trace, respectively;
a first plating layer and a second plating layer disposed on the first and second substrate pads, respectively; and
an insulating layer that covers the first trace, the second trace, and the first residual section and the second residual section of the first plating inlet line, the insulating layer including a first opening through which the first plating layer and the second plating layer are exposed and including a second opening separating the first residual section of the first plating inlet line from the second residual section of the first plating inlet line,
wherein the first trace includes a recessed section on a side facing the second trace, and the second opening is disposed within the recessed section.

2. The package substrate of claim 1, wherein the first residual section and the second residual section of the first plating inlet line are disposed in the chip mounting region.

3. The package substrate of claim 1, wherein the first trace and the second trace extend in a first direction, and the first residual section of the first plating inlet line and the second residual section of the first plating inlet line are aligned in a row along a second direction intersecting the first direction.

4. The package substrate of claim 1, wherein the first wiring includes a ground wiring or a power wiring, and the second wiring includes a signal wiring.

5. The package substrate of claim 1, further comprising:
a third residual section of a second plating inlet line disposed on the substrate body and exposed by a trace opening of the first wiring, the third residual section having one end connected to the first wiring;
a fourth residual section of the second plating inlet line disposed on the substrate body and exposed by the trace opening;
a third wiring disposed on the substrate body, the third wiring including a third substrate pad on the bonding finger region and a third trace connected to the third substrate pad, the third trace extending to the chip mounting region;
a third plating layer disposed on the third substrate pad; and
a connection circuit connecting the fourth residual section of the second plating inlet line and the third wiring.

6. The package substrate of claim 5, wherein the trace opening is disposed in the chip mounting region.

7. The package substrate of claim 5, wherein the insulating layer covers the third wiring and covers the third residual section and the fourth residual section of the second plating inlet line, and wherein the insulating layer further includes a third opening that separates the third residual section of the second plating inlet line from the fourth residual section of the second plating inlet line.

8. The package substrate of claim 7, wherein the third opening is disposed within the trace opening.

9. The package substrate of claim 5, wherein the connection circuit includes:
a first via connected to the fourth residual section of the second plating inlet line;
a second via connected to the third wiring; and
a connection wiring connecting the first via and the second via.

10. The package substrate of claim 9, further comprising an internal wiring layer disposed between a first surface of the substrate body and a second surface of the substrate body opposite to the first surface,
wherein the connection wiring is included in the internal wiring layer.

11. The package substrate of claim 1, wherein the first wiring includes a plurality of through holes through which the substrate body is exposed.

12. The package substrate of claim 11, wherein the first wiring is configured so that the plurality of through holes are not exposed on a side of the first wiring contacting the first residual section of the first plating inlet line.

13. A semiconductor package comprising:
a package substrate;
a semiconductor chip mounted on the package substrate; and
a first connection member and a second connection member connecting the package substrate and the semiconductor chip,
wherein the package substrate comprises:
a substrate body, wherein the semiconductor chip is mounted in a chip mounting region of the substrate body;
a first wiring including a first bonding finger disposed on the substrate body in a bonding finger region of the substrate body, the first bonding finger bonded to the first connection member, the first wiring also including a first trace disposed on the substrate body, the first trace connected to the first bonding finger and extending to the chip mounting region;
a second wiring including a second bonding finger disposed on the substrate body in the bonding finger region, the second bonding finger bonded to the second connection member, the second wiring also including a second trace disposed on the substrate body, the second trace connected to the second bonding finger and extending to the chip mounting region;
a first residual section of a first plating inlet line and a second residual section of the first plating inlet line disposed on the substrate body, the first and second residual sections connected to the first and second traces, respectively; and
an insulating layer covering the first trace, the second trace, and the first and second residual sections of the first plating inlet line, the insulating layer having a first opening through which the first bonding finger and the second bonding finger are exposed and a second opening separating the first residual section of the first plating inlet line from the second residual section of the first plating inlet line,
wherein the first trace includes a recessed section on a side facing the second trace, and the second opening is disposed within the recessed section.

14. The semiconductor package of claim 13, wherein the first residual section and the second residual section of the first plating inlet line are disposed in the chip mounting region.

15. The semiconductor package of claim 13, wherein the package substrate further comprises:
a third residual section of a second plating inlet line disposed on the substrate body and exposed by a trace opening of the first wiring, the third residual section having one end connected to the first wiring;
a fourth residual section of the second plating inlet line disposed on the substrate body and exposed by the trace opening;
a third wiring disposed on the substrate body, the third wiring including a third bonding finger in the bonding finger region and a third trace connected to the third bonding finger, the third trace extending to the chip mounting region; and
a connection circuit connecting the fourth residual section of the second plating inlet line and the third wiring.

16. The semiconductor package of claim 15, wherein the trace opening is disposed in the chip mounting region.

17. The semiconductor package of claim 15, wherein the connection circuit comprises:
a first via connected to the fourth residual section of the second plating inlet line;
a second via connected to the third wiring; and
a connection wiring connecting the first via and the second via.

18. The semiconductor package of claim 15, wherein the insulating layer covers the third wiring and covers the third residual section and the fourth residual section of the second plating inlet line,
wherein the insulating layer further includes a third opening separating the third residual section of the second plating inlet line from the fourth residual section of the second plating inlet line.

19. The semiconductor package of claim 18, wherein the third opening is disposed within the trace opening.

20. The semiconductor package of claim 13, wherein each of the first connection member and the second connection member includes a bonding wire.
